# EUROPEAN PATENT APPLICATION

(11) **EP 3 651 307 A1**
(43) Date of publication of application: **13.05.2020**
(21) Application number: 18205126.8
(22) Date of filing: 08.11.2018
(51) Int. Cl.: H02J 7/00, B60L 53/18, H02G 11/00, G01R 19/00

(54) **CHARGING CABLE**

(71) Applicant: Vestel Elektronik Sanayi ve Ticaret A.S., 45030 Manisa (TR)
(72) Inventor: AK, Yusuf, 45030 Manisa (TR); YALIN, Nevzat, 45030 Manisa (TR)
(74) Representative: Flint, Adam

(57) **Abstract**

A cable (3) for carrying electric current to charge a battery (4) has a thermochromic region (10). The thermochromic region (10) changes colour according to the level of heat produced by current flowing through the cable (3). This provides an indication of the level of current flowing through the cable (3). A light detector (20) may be provided for detecting light reflected by the thermochromic region (10). The light detector (20) has a response that depends on the colour of light reflected by the thermochromic region (10).

## Description

### Technical Field

The present disclosure relates to a cable for carrying electric current to charge a battery.

### Background

Rechargeable batteries are used in many devices and apparatus. Rechargeable batteries typically need to be recharged from time to time. In many cases, this is carried out by connecting the battery to a battery charger using a cable. In many cases, it is useful, and indeed sometimes necessary, to monitor the level of current which is flowing through the cable to charge the battery. In many cases, it is useful to provide an indication of the level of current which is flowing through the cable for a user.

### Summary

According to an aspect disclosed herein, there is provided a cable for carrying electric current to charge a battery, the cable having a thermochromic region which changes colour according to the level of heat produced by current flowing through the cable thereby to provide an indication of the level of current flowing through the cable.

In an example, this enables a user to obtain immediately am indication of the level of current flowing through the cable simply by visually inspecting the thermochromic region of the cable in use.

There may be provided, in combination, a cable as described above and a light detector for detecting light reflected by the thermochromic region, the light detector being constructed and arranged to have a response that depends on the colour of light reflected by the thermochromic region.

An output of the light detector may be used to provide an indication of the level of current flowing in the cable, which may be output as a display for a user and/or used by a charging station for control and safety purposes.

In an example, the light detector is a light-dependent resistor, LDR.

In general, the response of an LDR depends on the wavelength of the light incident on the LDR, such that different wavelengths light incident on the LDR result in the LDR having different resistances.

There may be provided, in combination, a cable as described above and a light source for emitting light towards the thermochromic region.

In an example, the light source is configured to emit light having a plurality of wavelengths.

For example, the light source may be a single light source which is arranged to emit white light. As another example, the light source may be provided by plural individual light sources which emit light of different colours. Each light source may emit light of a single wavelength or a narrow range of wavelengths.

There may be provided, in combination, a cable as described above and a light source drive circuit arranged to drive the light source to emit light of different wavelengths at different times.

For example, the light source, which may be provided by plural individual light sources, may be driven so as to cycle through emitting different wavelengths at different times.

In an example, the light detector is provided as a component of the cable.

For example, the light detector may be effectively permanently attached to the cable, or fixed to the cable in use at least.

Where present, the light source and the light source drive circuit may also be provided as a component of the cable.

In an example, the light detector is provided as a component of a charging station for use with the cable to charge an electric vehicle.

Where present, the light source and the light source drive circuit may also be provided as a component of the charging station.

### Brief Description of the Drawings

To assist understanding of the present disclosure and to show how embodiments may be put into effect, reference is made by way of example to the accompanying drawings in which:
Figure 1 shows schematically an example of a vehicle charging station charging a vehicle via a cable; and,
Figure 2 shows schematically a more detailed view of a portion of the cable of Figure 1 and a light emitter and light detector arrangement.

### Detailed Description

As mentioned, rechargeable batteries are used in many devices and apparatus and typically need to be recharged from time to time. This is often carried out by connecting the battery to a battery charger using a cable. Examples described herein may have application to charging of many types of batteries as used in many different types of device and apparatus. However, examples described herein have particular application to charging of batteries as used in electric and hybrid electric vehicles, such as automobiles, etc.

For safety and efficiency purposes, the current flowing through the charging cable must be controlled to prevent overly high current flow. In addition, it is convenient to provide an indication for a user that current is flowing through the cable to charge the vehicle and an indication of the level of current flowing through the cable.

In examples described herein, a cable for carrying electric current to charge a battery has a thermochromic region. The thermochromic region changes colour according to the level of heat produced by current flowing through the cable. This therefore provides an indication of the level of current flowing through the cable. This may be provided as a simple visual confirmation to a user that current is flowing through the cable and also the level of the current flowing through the cable. Alternatively or additionally, light reflected from the thermochromic region may be detected using a light detector that has response that depends on the colour of light reflected by the thermochromic region. The output of the light detector may be used to control a display output to provide an indication that current is flowing through the cable and the level of the current. Alternatively or additionally, it may be possible to use the output of the light detector as part of a control to control the level of current flowing through the cable.

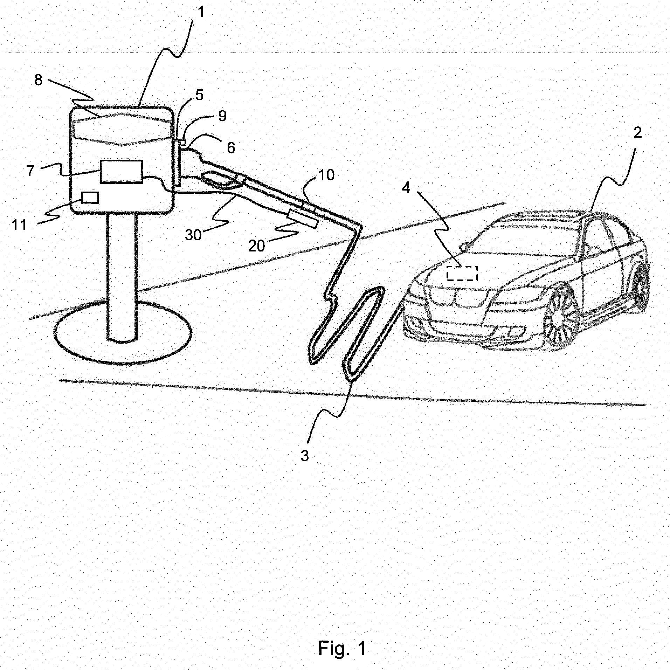

Referring now to Figure 1, there is shown an example of a battery charging apparatus 1 connected to an electric vehicle 2 by a charging cable 3.

The electric vehicle 2 includes a rechargeable battery 4 for supplying electrical energy to propel the vehicle 2. The vehicle 2 may be any type of vehicle that is capable of being propelled at least temporarily or partially by electrical energy stored in a rechargeable battery, including for example a hybrid electric vehicle or a fully electric vehicle.

The battery charging apparatus 1 in this example is in the form of a charging station. The battery charging apparatus 1 has a socket 5 arranged to receive a corresponding plug 6 provided at one of the charging cable 3 so as to connect the charging cable 3 to the battery charging apparatus 1. The vehicle 1 likewise has a socket (not shown) arranged to receive a corresponding plug (not shown) at the other end of the charging cable 3.

The battery charging apparatus 1 has a controller 7, which may be provided by one or more processors or a microcontroller, etc., to provide for overall control of the battery charging apparatus 1. The battery charging apparatus 1 has a display screen 8 for displaying information for the user. Other display arrangements may be provided on the battery charging apparatus 1, in addition to or instead of the display screen 8. For example, there may be one or more coloured lights 9 around or in the region of the socket 5 which are illuminated under control of the controller 7 according to for example the level of current flowing through the cable 3 during charging. The display screen 8 and/or the one or more coloured lights 9 may be illuminated with different colours and/or different lighting sequences depending on the level of current flowing through the cable 3 during charging. The display screen 8 may display numerically the level of current flowing through the cable 3 during charging, such as 16 A, 32 A, etc. The display screen 8 and/or the one or more coloured lights 9 may also be used to indicate the level of charge of the vehicle battery 4.

The charging cable 3 is typically a length of copper wire or wires encased in a sheath. The charging cable 3 has a thermochromic region 10. In this example, the thermochromic region 10 is provided by a coating of one or more thermochromic substances around the exterior surface of a portion of the cable 3. The thermochromic substances may be one or more paints or dyes or polymers, etc.

Thermochromism is the property of some substances to change colour due to a change in temperature. A specific temperature results in the substance exhibiting a specific colour. At least some thermochromic substances respond quickly to changes of temperature. The colour of the thermochromic region 10 at any particular time can therefore be taken as an indication of the temperature of the thermochromic region 10 at that time. In turn, because an electric current flowing through the cable 3 will heat the cable 3 due to the Joule effect, the colour of the thermochromic region 10 at any particular time can be taken as an indication of the level of current flowing through the cable 3. As is known, the power P of heating generated by an electrical conductor carrying a current is proportional to the product of the square of the current I and the electrical resistance R of the electrical conductor: PαI²R. Therefore, a particular current flowing in a particular cable 3 will produce a specific amount of heating of the cable 3 and therefore a specific temperature of the cable 3. (For completeness, it is mentioned that for example different ambient temperatures in the region of the cable 3 may affect the actual temperature of the cable 3 and the thermochromic region 10 that is reached. This will be discussed further below.)

In use, as a first level of indication for a user of the level of current flowing through the cable 3, the user can rapidly see that the colour of the thermochromic region 10 of the cable 3 has changed when current is flowing. The cable 3 may for example have a black sheath. The materials used for the thermochromic region 10 may be selected to indicate different levels of current flowing through the cable 3, dependent on for example the electrical resistance R of the cable 3. Accordingly, the user can easily and immediately see not only that charging is taking place, but also see that a particular current having a particular value is flowing through the cable 3 because the thermochromic region 10 is displaying a particular colour.

It may be noted that this sensing of the current is an indirect sensing. That is, it is a non-invasive method and is inherently isolated from the load or current being carried by the charging cable 3. It is therefore suitable for high currents and/or high voltages. This may be contrasted with directing sensing methods which are effectively invasive as some of the current flowing through the electrical conductor is tapped to flow through a sense resistor.

In charging of electric vehicles, various charging types or "modes" are typically used and some are defined by international Standards. For example, the supply voltage provided by the battery charging apparatus 1 may be (nominally) 120 V, 230 or 240 V, 400 V, 600 V or more, and the supply current may be 16 A, 32 A, 63 A or even higher, up to say 250 A for an AC (alternating current) supply and up to 400 A for a DC (direct current) supply.

Given particularly the large differences in the levels of charging current that may be used depending on the charging mode or the particular charging circumstances, in at least some examples the indication of the level of the charging current that is given by a visual inspection of the thermochromic region 10 does not have to be particularly accurate or sensitive. That is, at least for a visual inspection of the thermochromic region 10, it is sufficient that a particular colour indicates a particular temperature and therefore a particular colour with only moderate accuracy. For example, the thermochromic substances used for the thermochromic region 10 may be such that the temperature of the thermochromic region 10 and therefore the current flowing through the cable 3 are only indicated or effectively measured with an accuracy of say ± 10% or even say ± 50% or so, and that may be sufficient for the user to know that a particular charging mode, with a particular charging current, is being employed.

This use of a thermochromic region 10 on the charging cable 3 to provide an indication of the level of current flowing through the cable 3 is inexpensive and avoids use of current sense circuits or other such circuity in the cable 3. The cable 3 may be used in for example Mode 1 charging, which is slow charging from a standard domestic electrical single- or three-phase socket.

In the example shown, there is also a light detector arrangement 20 for viewing the thermochromic region 10 of the charging cable 3 and detecting the colour of the thermochromic region 10. The light detector arrangement 20 is arranged to face the thermochromic region 10 of the charging cable 3 to receive light from the thermochromic region 10 and detect the colour of the thermochromic region 10. The light detector arrangement 20 may have for example one or more light-dependent resistors (LDRs), also known as photoresistors. An LDR is a light-controlled variable resistor. The resistance of an LDR typically decreases with increasing incident light intensity. Moreover, an LDR tends to respond differently according to the colour (wavelength) of the incident light. This can be used to determine the colour of the light incident on the LDR in this example.

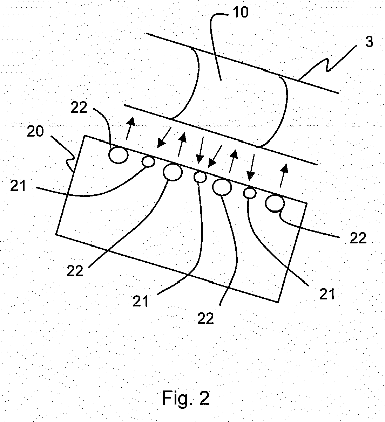

Referring additionally to Figure 2, this shows an example of a light detector arrangement 20 for use with the cable 3. The light detector arrangement 20 has at least one light detector 21. In the example shown, there are three light detectors 21 which are spaced at intervals along one side of the light detector arrangement 20 to face in use the thermochromic region 10 on the cable 3. The light detectors 21 are each arranged to be sensitive to different colours, with one light detector 21 being sensitive to a first colour, a second light detector 21 being sensitive to a second, different colour, etc. Each light detector 21 may be for example an LDR, as discussed above.

In addition to the light detectors 21, this example of a light detector arrangement 20 also has at least one light source 22. In the example shown, there are four light sources 22 which are spaced at intervals along one side of the light detector arrangement 20 to face in use the thermochromic region 10 on the cable 3. The light sources 22 alternate with the light detectors 21. The light sources 22 may all emit white light. In another example, the light sources 22 may emit light of different colours. The light emitted by at least some of the light sources 22 may be of the same colour (wavelength) as the sensitive portion of the response curve of the respective light detectors 21. That is, in effect, in this example there may be several light sources 22 and several light detectors 21 which are respectively "tuned" to each other so as to emit light and be sensitive to light of the same colour (wavelength). In addition to these "tuned" corresponding light sources 22 and the light detectors 21, there may be a light source 22 that emits white light (i.e. all wavelengths, or at least all visible wavelengths).

In use in an example, the light detector arrangement 20 is connected to the battery charging apparatus 1 to send control signals, or at least the outputs of the or each light detector 21, to the battery charging apparatus 1. In an example, the light detector arrangement 20 is also connected to the battery charging apparatus 1 to receive power from the battery charging apparatus 1 to power the or each light source 22 and to power any other components or circuitry that need electrical power. This is indicated schematically by a separate power and signal cable 30 between the light detector arrangement 20 and the battery charging apparatus 1. The cable 30 is connected to the controller 7 of the battery charging apparatus 1. Whilst a separate power and signal cable 30 is shown in Figure 2, the cable 30 connecting the light detector arrangement 20 and the battery charging apparatus 1 may be provided integrally with or attached to the main charging cable 3.

In use when the charging cable 3 is connected to the battery charging apparatus 1 and the vehicle 2 to be charged via the charging cable 3, the controller 7 of the battery charging apparatus 1 causes electrical power to be delivered to the vehicle 3 via the charging cable 3. The controller 7 of the battery charging apparatus 1 also commands the or each light source 22 of the light detector arrangement 20 to emit light. The light is incident on the thermochromic region 10 on the cable 3. At least some of the light is reflected by the thermochromic region 10 and is received by one or more light detectors 21 of the light detector arrangement 20. This is indicated schematically by arrows in Figure 2. The light that is emitted by the or each light source 22 is either white light (i.e. all wavelengths, or at least all visible light wavelengths) or is light of a single wavelength or a narrow band of wavelengths. In the case that there are plural light sources 22 that emit light of different colours, the light sources 22 may be controlled to emit light of different colours separately in sequence, such that a first colour is emitted during a first time slot, a second colour is emitted during a second time slot, etc. Each different colour may be emitted at intervals of say 0.5 ms.

Light that is incident on the thermochromic region 10 and that has the same colour as the thermochromic region 10 will be reflected by the thermochromic region 10 with a higher intensity than incident light that has a colour that is different from the colour of the thermochromic region 10. The use of the one or more light sources 22 to generate light of different colours, which may be applied to the thermochromic region 10 one colour at a time in turn, can increase the sensitivity of the light detector arrangement 20.

A light-dependent resistor is typically connected to a voltage divider (or "potential divider") circuit for operation. There are two configurations of the circuit depending upon the position of the LDR within the potential divider network. In one, the voltage output (Vout) increases as the intensity of light increases and, in the other, the voltage output decreases as the intensity of light increases. A potential divider circuit may be provided in the light detector arrangement 20 for each light source 22 when implemented using LDRs. A measure of the voltage output by the voltage dividers for the light detectors 21 can thereby be used to obtain an indication of the colour of the thermochromic region 10, which, in turn, indicates the level of the current flowing through the charging cable 3.

In general, different charging cables 3 will have different electrical resistances, depending on for example the expected charging current and voltage that the charging cable 3 is likely to carry in use.

Accordingly and bearing this in mind, in one example, the thermochromic materials applied to the thermochromic region 10 may be selected at least in part depending on the resistance of the cable 3. In this way, it may be arranged that for all cables, regardless of their electrical resistance, the same current through the cable results in the same colour at the thermochromic region 10 (at least approximately). As a simple illustrative example, red may always indicate a current of 16 A, blue may always indicate a current of 32 A, etc.

In such a case, the battery charging station 1 simply needs to know the colour of the thermochromic region 10 at a particular time in order to obtain a measure of the current flowing through the cable 3 at that time. The battery charging apparatus 1 may have a look-up table stored in data storage 11 which shows for example a correspondence between the colour of the thermochromic region 10 and the current flowing through the cable 3. The light detector arrangement 20 may have circuitry that determines which light detector 21 is indicating a highest light intensity and therefore the colour of the thermochromic region 10, and indicates that colour to the battery charging apparatus 1 over. From that colour, the controller 7 of the battery charging apparatus 1 can access the look-up table to obtain a measure of the current flowing through the cable 3. The look-up table may take into account local conditions, such as for example ambient temperature, to improve the accuracy of this as higher or lower ambient temperatures will affect the temperature of the charging cable 3 for a particular current.

As another example of this, the light detector arrangement 20 may provide the voltages of the voltage dividers for the light detectors 21 to the battery charging station 1. The battery charging station 1 may have a look-up table stored in data storage 11 which shows for example a correspondence between the output voltages at the voltage dividers of the light detectors 21 and the current flowing through the cable 3.

Either way in such cases, the light detector arrangement 20 may be provided as part of the charging station 1 as, in this sense, the light detector arrangement 20 is "universal" and can be used with any cable 3 having a thermochromic region 10 that is arranged in such a way. For example, the light detector arrangement 20 may be effectively permanently connected to the charging station 1, via the power and signal cable 30, and is connected to the charging cable 3 by the user when a vehicle 2 is to be charged. The battery charging station 1 obtains an indication of the colour being displayed by the thermochromic region 10. The battery charging station 1 can display on the display screen 8 the numerical value of current flowing through the cable 3 during charging, such as 16 A, 32 A, etc. Alternatively or additionally, it may be possible for the battery charging station 1 to use the output of the light detector arrangement 20 as part of a control to control the level of current flowing through the cable 3.

In another example, the same thermochromic material(s) may be applied to each charging cable 3, regardless of for example the electrical resistance of the cable 3. That would mean that the same current would produce different colours in the cables, depending particularly on the resistance of the cable. In that case, the light detector arrangement 20 may be part of the cable 3, such as being permanently fixed to the cable 3, or gets supplied with the cable 3 to be fixed to the cable 3 by the user when charging is taking place. Some circuitry on the cable 3, which may be part of the light detector arrangement 20, knows that a certain colour means a certain current for that particular cable 3. The cable 3 and the circuitry may be calibrated during manufacture, for example. The circuitry can inform the battery charging station 1 what the level of the current is based on the colour. The light detector arrangement 20 for a particular cable 3 may have a look-up table stored in some data storage which contains a correspondence between colour of the thermochromic region 10 and the current flowing through that particular cable 3. This effectively calibrates the light detector arrangement 20 for that cable 3. Again, the battery charging station 1 can display on the display screen 8 the numerical value of current flowing through the cable 3 during charging, such as 16 A, 32 A, etc. Alternatively or additionally, it may be possible for the battery charging station 1 to use the output of the light detector arrangement 20 as part of a control to control the level of current flowing through the cable 3.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Reference is made herein to data storage for storing data. This may be provided by a single device or by plural devices. Suitable devices include for example a hard disk and non-volatile semiconductor memory (including for example a solid-state drive or SSD).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A cable for carrying electric current to charge a battery, the cable having a thermochromic region which changes colour according to the level of heat produced by current flowing through the cable thereby to provide an indication of the level of current flowing through the cable.

2. In combination, a cable according to claim 1 and a light detector for detecting light reflected by the thermochromic region, the light detector being constructed and arranged to have a response that depends on the colour of light reflected by the thermochromic region.

3. A combination according to claim 2, wherein the light detector is a light-dependent resistor, LDR.

4. A combination according to claim 2 or claim 3, and a light source for emitting light towards the thermochromic region.

5. A combination according to claim 4, wherein the light source is configured to emit light having a plurality of wavelengths.

6. A combination according to claim 5, and a light source drive circuit arranged to drive the light source to emit light of different wavelengths at different times.

7. A combination according to any of claims 2 to 6, wherein the light detector is provided as a component of the cable.

8. A combination according to any of claims 2 to 6, wherein the light detector is provided as a component of a charging station for use with the cable to charge an electric vehicle.
